# EUROPEAN PATENT APPLICATION

(11) **EP 3 975 280 A1**
(43) Date of publication of application: **30.03.2022**
(21) Application number: 21153449.0
(22) Date of filing: 26.01.2021
(51) Int. Cl.: H01L 51/54

(54) **COMPOSITION FOR ORGANIC ELECTROLUMINESCENT ELEMENT AND ORGANIC ELECTROLUMINESCENT ELEMENT**

(30) Priority: 29.09.2020 JP 2020163740
(71) Applicant: NIPPON STEEL Chemical & Material Co., Ltd., Tokyo 103-0027 (JP)
(72) Inventor: Ogawa, Junya, Tokyo 103-0027 (JP); Ikenaga, Yuji, Tokyo 103-0027 (JP); Kai, Takahiro, Tokyo 103-0027 (JP); Hayashi, Kentaro, Tokyo 103-0027 (JP); Ueda, Tokiko, Tokyo 103-0027 (JP); Terada, Ayaka, Tokyo 103-0027 (JP)
(74) Representative: Gerauer, Marc Philippé

(57) **Abstract**

Provided are an organic EL element having high efficiency or long life while having a low drive voltage, and a combination of compounds suitable therefor. In the organic EL element, at least one light-emitting layer includes a first compound represented by following formula (1), a second compound represented by following formula (2), and a luminous dopant material; 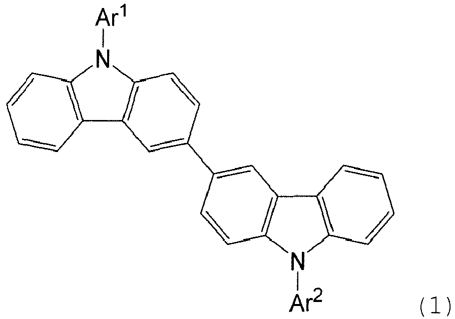 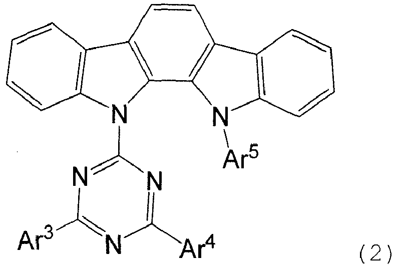 Ar¹ and Ar² are each a phenyl or a biphenylyl, Ar³ and Ar⁴ are each a phenyl, a biphenylyl, a terphenylyl or a dibenzofuranyl and the like, and Ar⁵ is a phenyl, biphenylyl or terphenylyl.)

## Description

### [Field of the Invention]

The present invention relates to a composition for an organic electroluminescent element and an organic electroluminescent element using the same.

### [BACKGROUND OF THE INVENTION]

Where a voltage is applied to an organic electroluminescent element (referred to as an organic EL element), holes from an anode and electrons from a cathode are injected into a light-emitting layer. The injected holes and electrons are recombined in the light-emitting layer to generate excitons. At this time, singlet excitons and triplet excitons are generated at a ratio of 1:3 according to the statistical law of electron spin. It is said that the internal quantum efficiency of a fluorescent type organic EL device that uses light emission by a singlet exciton will be limited to 25%. Meanwhile, it is known that in a phosphorescent organic EL element that uses light emission by triplet excitons, the internal quantum efficiency can be increased to 100% when intersystem crossing is efficiently performed from singlet excitons.

However, further improvement in efficiency and extension of life are technical problems associated with phosphorescent organic EL devices.

More recently, high-efficiency organic EL devices using delayed fluorescence have been developed. For example, Patent Literature 1 discloses an organic EL device using a TTF (Triplet-Triplet Fusion) mechanism, which is one of the delayed fluorescence mechanisms. The TTF mechanism uses the phenomenon that singlet excitons are generated by the collision of two triplet excitons, and it is theoretically conceivable that the internal quantum efficiency can be increased up to 40%. However, since the efficiency is lower than that of phosphorescent organic EL devices, further improvement in efficiency is required.

Meanwhile, Patent Literature 2 discloses an organic EL device that uses a TADF (Thermally Activated Delayed Fluorescence) mechanism. The TADF mechanism uses the phenomenon that the intersystem crossing from a triplet exciton to a singlet exciton occurs in a material in which the energy difference between the singlet level and the triplet level is small, and it is theoretically conceivable that the internal quantum efficiency can be increased to 100%. However, as with phosphorescent devices, further improvement in efficiency characteristics and life characteristics is required.

### [Prior Art Documents]

### [Patent Literature]

[PTL 1] WO2010/134350A
[PTL 2] WO2011/070963A
[PTL 3] JP2014-157947A
[PTL 4] KR2014-096203A
[PTL 5] WO2018/198844A
[PTL 6] WO2018/061446A

Patent Literatures 3 and 4 disclose using a biscarbazole compound as a mixed host.

Patent Literatures 5 and 6 disclose using an indolocarbazole compound and a biscarbazole compound as a mixed host.

However, further improvement in the characteristics of organic EL devices is desired.

### [Summary of the invention]

### [Problem to be solved by the invention]

The share of panels using organic EL elements in a small- and medium-sized panel market such as smartphones has been expanding, but further improvements in characteristics such as improvement in luminous efficiency, decrease in voltage, and improvement in life characteristics of the elements are necessary. An object of the present invention is to provide a practically useful organic EL device having high luminous efficiency or long life characteristics while having a low drive voltage.

### [Means for solving the problem]

The present invention provides an organic electroluminescent element including an anode and a cathode that face each other, and one or more light-emitting layers that are present between the anode and the cathode, wherein at least one light-emitting layer contains a first compound selected from compounds represented by following formula (1), a second compound selected from compounds represented by following general formula (2), and a luminous dopant material.

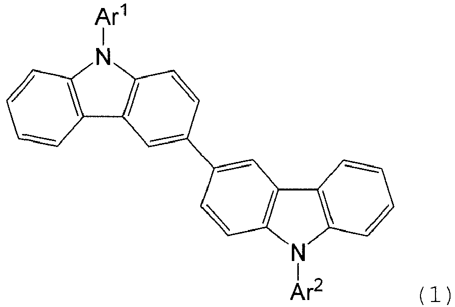

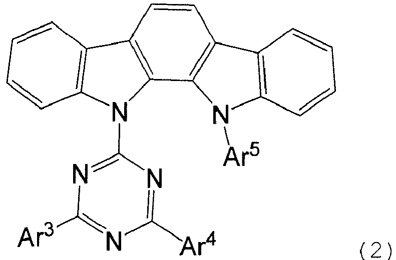

In formula (1), Ar¹ is represented by any of following formulas (1A) to (1D), and Ar² is represented by any of following formulas (1B) to (1D).

In formula (2), Ar³ and Ar⁴ are independently represented by any one selected from the group consisting of following formulas (1A) to (1D) and formulas (2A) to (2F), and Ar⁵ is represented by any one selected from the group consisting of following formulas (1A) to (1D) and formulas (2A) to (2C).

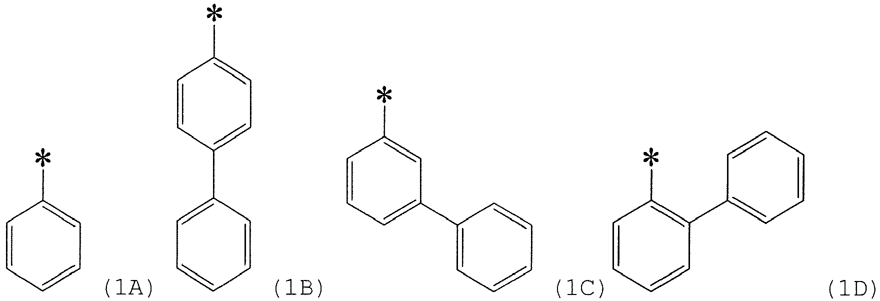

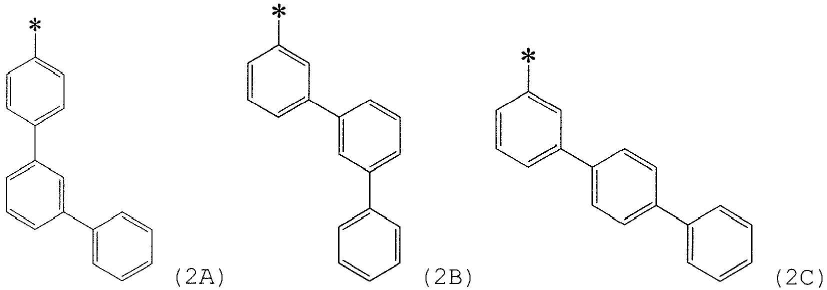

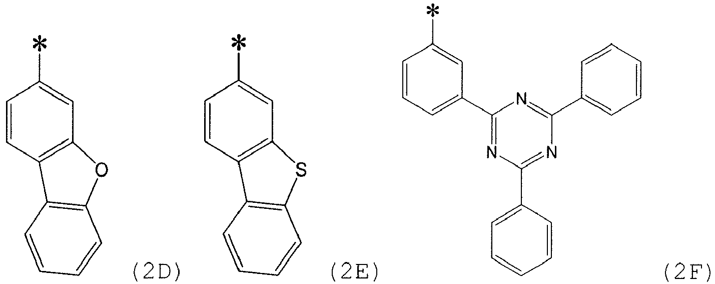

Here, * represents a bonding position.

However, the cases where Ar¹ in formula (1) is formula (1A) and Ar² is formula (1B), Ar³ in formula (2) is formula (1A), Ar⁴ is formula (1B), and Ar⁵ is formula (1C), or Ar³ is formula (1A), Ar⁴ is formula (1A), and Ar⁵ is formula (2B) are excluded.

Examples of the compounds represented by formula (1) include compounds represented by any one of following formulas 1-1 to 1-9, and examples of the compounds represented by formula (2) include compounds represented by any one of following formulas 2-1 to 2-17: 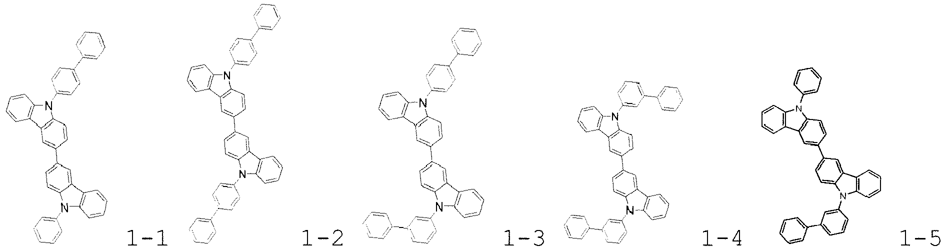 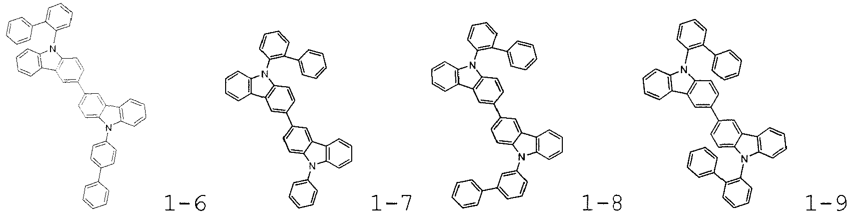 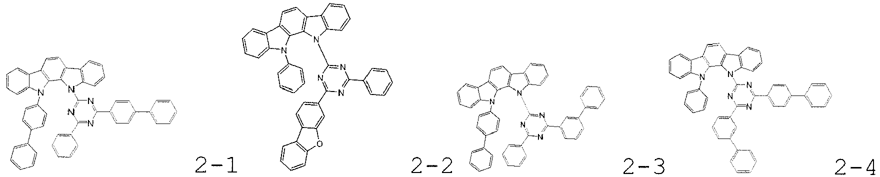 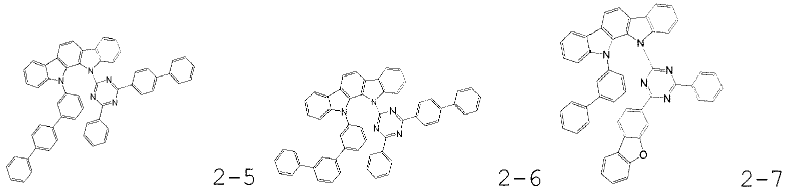 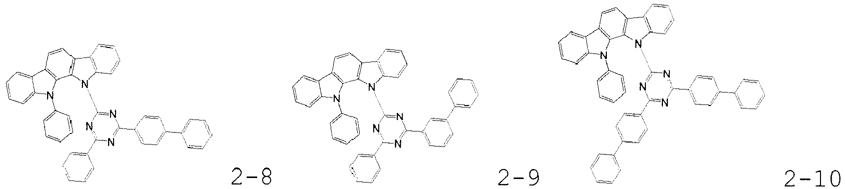 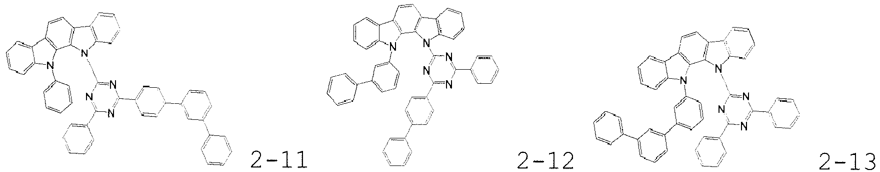 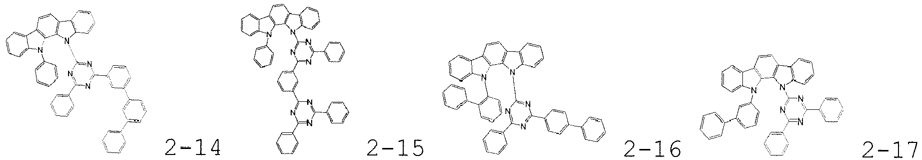 provided that, a case where the first compound is of formula 1-1 and the second compound is of formula 2-12 or 2-13 is excluded.

Preferably, the first compound is a compound represented by any one of formulas 1-1 to 1-4, and the second compound is any one of formulas 2-1 to 2-11.

More preferably, the second compound is a compound represented by any one of formulas 2-1 to 2-7.

The proportion of the second compound may be more than 20 wt% and less than 60 wt% with respect to the total of the first compound and the second compound.

Examples of the luminous dopant material include fluorescent dopant materials including an organometallic complex including at least one metal selected from the group consisting of ruthenium, rhodium, palladium, silver, rhenium, osmium, iridium, platinum, and gold, or a thermally activated delayed fluorescence luminous material.

The present invention also provides a method for producing an organic electroluminescent element, the method being for producing the organic electroluminescent element according to any one of claims 1 to 7, and the method comprising: preparing a composition that contains the first compound and the second compound, and a step of forming a light-emitting layer by vapor-depositing or coating this composition.

Examples of a method for producing an organic electroluminescent element by vapor deposition include a method including mixing the first compound and the second compound to obtain a composition composed of a premixture, and forming a light-emitting layer by vapor-depositing a material containing this composition and a luminous dopant material.

In this case, it is desirable that the difference in the 50% weight loss temperature between the first compound and the second compound be within 20°C.

Further, the present invention also provides a composition for an organic electroluminescent device, the composition being for use in the method for producing an organic electroluminescent device, and the composition including the first compound and the second compound. Preferably, provided is a composition containing the premixture.

### [Effects of the Invention]

In an organic EL device, excitons are generated by recombination in a light-emitting layer of holes and electrons generated when a voltage is applied, but where the recombination region is biased toward an anode side or a cathode side, it is expected that the voltage will rise due to insufficient charge, the efficiency will decrease due to exciton leakage, and the life will decrease due to the increased load on the light-emitting dopant material and host material. Therefore, it is considered to be preferable to adjust the amount of holes and electrons injected into the light-emitting layer and the transportability of holes and electrons in the light-emitting layer so that the recombination region be widely distributed without bias. In the present invention, a biscarbazole compound having a hole injection/transport property and an indolocarbazole compound having an electron injection/transport property are used, and these are specifically combined to realize particularly well-balanced injection/transport property of holes and electrons. As a result, by adopting these features in a light-emitting layer host of an organic EL element, the load balance in the light-emitting layer is improved, and the drive voltage, light emission efficiency, and life characteristics of the element are improved.

### [Brief description of the drawing]

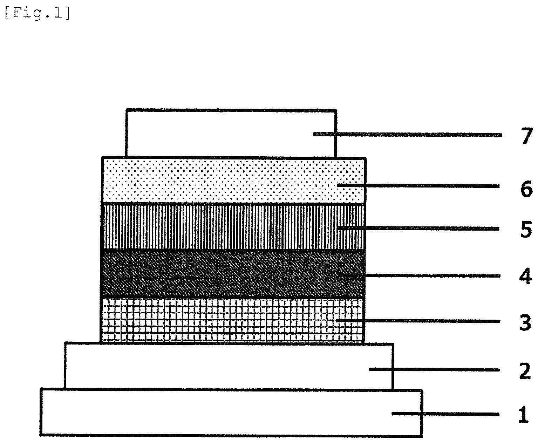

FIG. 1 is a cross-sectional view showing an example of a structure of an organic EL element.

### [Description of the preferred embodiments]

The organic electroluminescent element of the present invention includes one or more light-emitting layers between the anode and cathode facing each other, and at least one light-emitting layer includes the first compound, the second compound, and a luminous dopant material.

The first compound is represented by formula (1).

In formula (1), Ar¹ is a group represented by any of formulas (1A) to (1D), and Ar² is a group represented by any of formulas (1B) to (1D). Here, * represents a bonding position. Since Ar¹ and Ar² are equivalent, they may be interchanged.

The first compound is preferably represented by any one of formulas 1-1 to 1-9.

The second compound is represented by formula (2).

In formula (2), Ar³ and Ar⁴ are independently represented by any of the group consisting of formulas (1A) to (1D) and formulas (2A) to (2F), and Ar⁵ is represented by any of the group consisting of formulas (1A) to (1D) and formulas (2A) to (2C).

The second compound is preferably represented by any one of formulas 2-1 to 2-17.

The first compound is preferably included as a hole injection/transport host responsible for hole injection/transport in the light-emitting layer. Further, the second compound is preferably included as an electron injection/transport host responsible for injection/transport of electrons in the light-emitting layer.

Preferably, the first compound is represented by any one of formulas 1-1 to 1-4 and the second compound is represented by any one of formulas 2-1 to 2-11. More preferably, the second compound is represented by any one of formulas 2-1 to 2-7.

A more preferred combination of the first compound and the second compound is a combination in which the first compound is of formula 1-1 or formula 1-2 and the second compound is of formula 2-9 or formula 2-10.

In another embodiment, a combination is preferable in which the first compound is represented by any one of formulas 1-2, 1-3 and 1-4, and the second compound is represented by any one of formulas 2-8 and 2-13.

In yet another embodiment, a combination in which the first compound is represented by formula 1-2 or 1-4 and the second compound is represented by formula 2-11, or a combination in which the first compound is represented by formula 1-3 or 1-4 and the second compound is represented by formula 2-12 is preferable.

Other preferred embodiments of the combination of the first compound and the second compound are listed hereinbelow.
(1) First compound: formula 1-1, 1-2 or 1-3; second compound: formula 2-1, 2-2, 2-3 or 2-4.
(2) First compound: formula 1-2 or 1-3, second compound: formula 2-5 or 2-6.
(3) First compound: formula 1-2 or 1-3, second compound: formula 2-8 or 2-13.
(4) First compound: formula 1-1 or 1-2, second compound: formula 2-9.
(5) First compound: formula 1-1, second compound: formula 2-7.
(6) First compound: formula 1-1, second compound: formula 2-10.
(7) First compound: formula 1-2, second compound: formula 2-11.
(8) First compound: formula 1-4, second compound: formula 2-12.

The first compound and the second compound may be used one kind each or in combination of two or more kinds, but it is preferable to use one kind each.

The mixing ratio (weight ratio) of the first compound and the second compound is such that the proportion of the second compound may be more than 10 wt% and less than 70 wt%, preferably more than 15 wt% and less than 65 wt%, and more preferably more than 20 wt% and less than 60 wt%.

A phosphorescent light-emitting dopant material and a fluorescent light-emitting dopant material can be used as the luminous dopant material, and a fluorescent dopant material including a thermally activated delayed fluorescence luminous material is also suitable.

The organic electroluminescent element of the present invention can be produced by a known method. The light-emitting layer can be formed by a vapor deposition method or a coating method.

Advantageously, it is a production method including a step of preparing a composition including the first compound and the second compound, and a step of vapor-depositing or coating the composition to form a light-emitting layer.

As a preferred embodiment, it is a production method including a step of mixing the first compound and the second compound to form a composition composed of a premixture, and a step of vapor-depositing a material including the composition and a luminous dopant material to form a light-emitting layer.

In this case, it is desirable that the difference in the 50% weight loss temperature between the first compound and the second compound be within 20°C.

Further, a coating method having a step of forming an organic layer composed of a coating film of a composition including the first compound and the second compound can also be used.

As the coating method, various coating processes such as a spin coating method, a bar coating method, a spray method, an inkjet method, and a printing method can also be used. In this case, it is possible to coat a solution obtained by dissolving or dispersing the composition in a solvent (also referred to as a composition for an organic electroluminescent device) on a substrate, and then volatilizing the solvent by heating and drying to form an organic layer. At this time, the solvent used may be one of kind or a mixture of two or more kinds. Further, the solution may include a luminous dopant material such as phosphorescent, fluorescent, delayed fluorescence material, an additive and the like as the compound of the first compound and the second compound.

The composition for an organic electroluminescent element of the present invention includes the first compound and the second compound. Luminous dopant materials and host materials different from the first compound and second compound can be included as the other compounds.

However, when an organic electroluminescent element is produced by a vapor deposition method, it is preferable that the composition comprise the first compound and the second compound and include substantially no other compounds.

Such composition is exemplified by a composition composed of the premixture. The premixture may be obtained by a method of mechanically pulverizing and mixing, a method of melt-mixing, a method of dissolving and mixing, a method of vaporizing and mixing, etc. of the first compound and the second compound. A method of pulverizing and mixing or a method of melting and mixing is convenient and preferable.

The composition for an organic electroluminescent element of the present invention is contained in the light-emitting layer, and the first compound and the second compound are included as hosts.

This composition may be contained in an organic layer other than the light-emitting layer, and in this case, the composition may be included in a layer selected from the group consisting of a hole injection layer, a hole transport layer, an electron transport layer, an electron injection layer, a hole-blocking layer and an electron blocking layer.

Next, the structure of the organic EL device of the present invention will be described with reference to the drawings, but the structure of the organic EL device of the present invention is not limited thereto.

FIG. 1 is a cross-sectional view showing a structural example of a general organic EL device used in the present invention, in which 1 is a base plate, 2 is an anode, 3 is a hole injection layer, 4 is a hole transport layer, 5 is a light-emitting layer, 6 is an electron transport layer, and 7 is a cathode. The organic EL device of the present invention may have an exciton blocking layer adjacent to the light-emitting layer, or may have an electron blocking layer between the light-emitting layer and the hole injection layer. The exciton blocking layer can be inserted at either the anode side or the cathode side of the light-emitting layer, and can be inserted at both sides at the same time. The organic EL device of the present invention has the anode, the light-emitting layer, and the cathode as essential layers, but may have a hole injection/transport layer and an electron injection/transport layer in addition to the essential layers, and further may have a hole-blocking layer between the light-emitting layer and the electron injection/transport layers. The hole injection/transport layer means either the hole injection layer or the hole transport layer, or both, and the electron injection/transport layer means either the electron injection layer or the electron transport layer, or both.

It is also possible to stack the cathode 7, the electron transport layer 6, the light-emitting layer 5, the hole transport layer 4, and the anode 2 on the substrate 1 in this order which is opposite to the structure shown in FIG. 1, and in this case the layers can be added or omitted as necessary.

### Substrate

The organic EL element of the present invention is preferably supported by a substrate. The substrate is not particularly limited and any substrate that has been conventionally used for an organic EL element may be used. For example, a substrate made of glass, transparent plastic, quartz or the like can be used.

### Anode

As the anode material in the organic EL device, a material composed of a metal, an alloy, an electrically conductive compound, or a mixture thereof having a large work function (4 eV or more) is preferably used. Specific examples of such an electrode material include metals such as Au, and conductive transparent materials such as CuI, indium tin oxide (ITO), SnO₂, and ZnO. Further, an amorphous material such as IDIXO (In₂O₃-ZnO) that is capable of producing a transparent conductive film may be used. For the anode, these electrode materials may be formed into a thin film by a method such as vapor deposition or sputtering, and a pattern of a desired shape may be formed by a photolithography method, or when a high pattern accuracy is not required (about 100 µm or more), a pattern may be formed through a mask having a desired shape during vapor deposition or sputtering of the electrode material. Alternatively, when a coatable substance such as an organic conductive compound is used, a wet film forming method such as a printing method or a coating method can be used. When emitting light from this anode, it is desirable to increase the transmittance to more than 10%, and the sheet resistance of the anode is preferably several hundred Ω/□ or less. The film thickness depends on the material, but is usually selected in the range of 10 nm to 1000 nm, preferably 10 nm to 200 nm.

### Cathode

Meanwhile, as the cathode material, a material composed of a metal (electron-injecting metal), an alloy, an electrically conductive compound, or a mixture having a small work function (4 eV or less) is used. Specific examples of such electrode materials include sodium, sodium-potassium alloy, magnesium, lithium, magnesium/copper mixture, magnesium/silver mixture, magnesium/aluminum mixture, magnesium/indium mixture, aluminum/aluminum oxide (Al₂O₃) mixture, indium, lithium/aluminum mixture, rare earth metals, and the like. Among these, from the viewpoint of electron injectability and durability against oxidation, etc., a mixture of an electron-injecting metal and a second metal having a stable work function which is larger than that of the electron injecting metal, for example, magnesium/silver mixture, magnesium/aluminum mixture, magnesium/indium mixture, aluminum/aluminum oxide mixture, lithium/aluminum mixture, aluminum and the like are preferred. A cathode can be produced by forming a thin film of these cathode materials by a method such as vapor deposition or sputtering. The sheet resistance of the cathode is preferably several hundred Ω/□ or less, and the film thickness is usually selected in the range of 10 nm to 5 µm, preferably 50 nm to 200 nm. Where either the anode or the cathode of the organic EL element is transparent or semi-transparent in order to transmit the emitted light, the emission brightness is advantageously improved.

Further, a transparent or semi-transparent cathode can be produced by forming the metal on the cathode with a thickness of 1 nm to 20 nm and then forming the conductive transparent material mentioned in the description of the anode on the cathode. By adopting such a cathode, it is possible to manufacture a device in which both the anode and the cathode are transparent.

### Light-Emitting Layer

The light-emitting layer is a layer that emits light after excitons are generated by recombination of holes and electrons injected from the anode and cathode, respectively, and the light-emitting layer may contain an organic luminous dopant material and a host.

The first compound and the second compound are suitable as hosts (first host and second host). When the first compound and the second compound are vapor-deposited to form a light-emitting layer, these compounds can by individually vapor-deposited from different vapor deposition sources for use, but it is preferable that the two compounds be premixed before vapor deposition to form a premixture (composition for organic electric field light emitting device), and the premixture thereof be simultaneously vapor-deposited from one vapor deposition source to form a light-emitting layer. In this case, the premixture may be mixed with a luminous dopant material required to form the light-emitting layer or other hosts used as needed, but when there is a large difference in the temperature at which the desired vapor pressure is obtained, vapor deposition thereof may be done from a separate vapor deposition source.

The first compound and the second compound may be used as the host. If necessary, one or more other known host materials may be used singly or in combination of a plurality thereof, but the usage amount thereof is 50 wt% or less, preferably 25 wt% or less, based on the total amount of the host materials.

The host material or premixture thereof may have a powder, stick or granular form.

When a plurality of types of hosts is used, each host can be vapor-deposited from a respective vapor deposition source, or a plurality of types of hosts can be simultaneously vapor deposited from one vapor deposition source by premixing the hosts before the vapor deposition to form a premixture.

Mixing as uniformly as possible is desirable as the mixing method, and examples thereof include a pulverization and mixing method, a method of heating and melting under reduced pressure or in an inactive gas atmosphere such as nitrogen, and sublimation, but these methods are not limiting.

When the first host and the second host are premixed and used, it is desirable that the difference in 50% weight loss temperature (T₅₀) be small in order to produce an organic EL element having good characteristics with good reproducibility. The 50% weight loss temperature is the temperature at which the weight is reduced by 50% when the temperature is raised from room temperature to 550°C at a rate of 10°C per minute in TG-DTA measurement under nitrogen flow decompression (1 Pa). At around this temperature, vaporization by evaporation or sublimation is considered to occur most actively.

The difference between the first host and the second host in the 50% weight loss temperature is preferably 20°C or less, and more preferably 15°C or less. As the premixing method, a known method such as pulverization mixing can be adopted, but it is desirable to mix as uniformly as possible.

When a phosphorescent light-emitting dopant is used as the luminous dopant material, the phosphorescent light-emitting dopant may contain an organometallic complex including at least one metal selected from ruthenium, rhodium, palladium, silver, rhenium, osmium, iridium, platinum and gold. Specifically, an iridium complex described in J. Am. Chem. Soc. 2001, 123, 4304 and Japanese Translation of PCT Application No. 2013-530515 is preferably used, but is not limiting.

Only one kind of the phosphorescent light-emitting dopant material or two or more kinds thereof may be contained in the light-emitting layer. The amount of the phosphorescent light-emitting dopant material is preferably 0.1 wt% to 30 wt% and more preferably 1 wt% to 20 wt% with respect to the host material.

The phosphorescent light-emitting dopant material is not particularly limited, and specific examples thereof are listed hereinbelow.

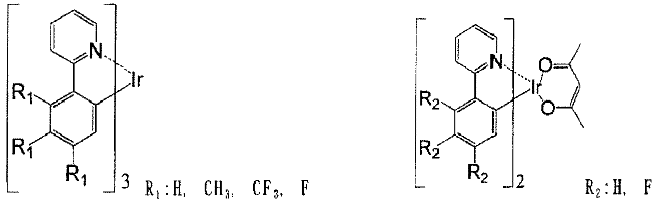

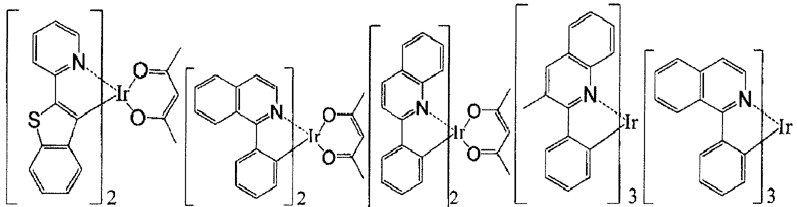

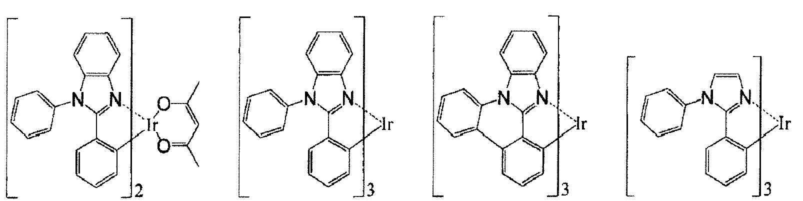

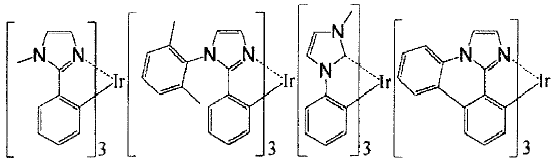

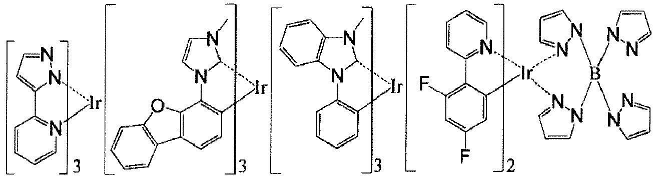

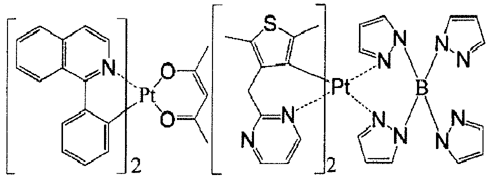

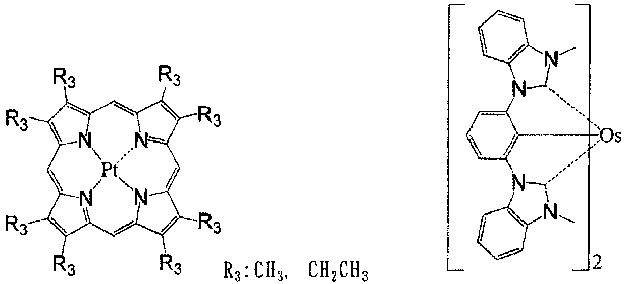

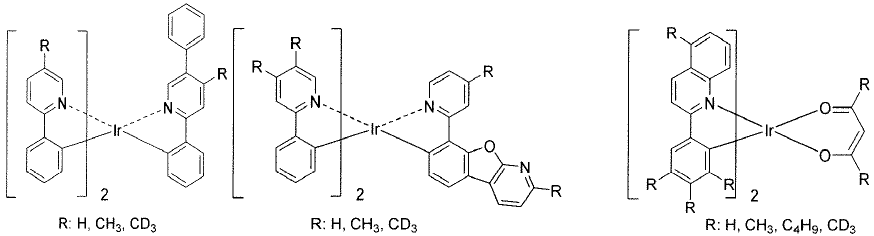

When a fluorescent light-emitting dopant is used as the luminous dopant material, the fluorescent light-emitting dopant can be exemplified by, but is not limited to, benzoxazole derivatives, benzothiazole derivatives, benzimidazole derivatives, styrylbenzene derivatives, polyphenyl derivatives, diphenylbutadiene derivatives, tetraphenylbutadiene derivatives, naphthalimide derivatives, coumarine derivatives, condensed aromatic compounds, perinone derivatives, oxadiazole derivatives, oxazine derivatives, aldazine derivatives, pyrrolidine derivatives, cyclopentadiene derivatives, bisstyrylanthracene derivatives, quinacridone derivatives, pyrolopyridine derivatives, thiadiazolopyridine derivatives, styrylamine derivatives, diketopyrrolopyrrole derivatives, various metal complexes represented by metal complexes of 8-quinolinol derivatives, metal complexes of pyromethene derivatives, rare earth complexes, and transition metal complexes, polymer compounds such as polythiophene, polyphenylene, and polyphenylene vinylene, organic silane derivatives, and the like. Preferred examples thereof include condensed aromatic derivatives, styryl derivatives, diketopyrrolopyrrole derivatives, oxazine derivatives, pyromethene metal complexes, transition metal complexes, and lanthanoid complexes, and more preferably naphthalene, pyrene, chrysene, triphenylene, benzo[c]phenanthrene, benzo[a]anthracene, pentacene, perylene, fluorantene, acenaphthofluoranthene, dibenzo[a,j]anthracene, dibenzo[a,h]anthracene, benzo[a]naphthalene, hexacene, naphtho[2,1-f]isoquinoline, α-naphthaphenanthridine, phenanthrooxazole, quinolino[6,5-f]quinoline, and benzothiophanthracene. These may have an alkyl group, an aryl group, an aromatic heterocyclic group, or a diarylamino group as a substituent.

Only one kind of the fluorescent light-emitting dopant material or two or more kinds thereof may be contained in the light-emitting layer. The amount of the fluorescent light-emitting dopant material is preferably 0.1% to 20% and more preferably 1% to 10% with respect to the host material.

When a thermally activated delayed fluorescence light-emitting dopant is used as the luminous dopant material, the thermally activated delayed fluorescence light-emitting dopant can be exemplified by, but is not limited to, metal complexes such as tin complexes, copper complexes, and the like, indolocarbazole derivatives described in WO2011/070963, cyanobenzene derivatives described in Nature 2012, 492, 234, carbazole derivatives, phenazine derivatives described in Nature Photonics 2014, 8, 326, oxadiazole derivatives, triazole derivatives, sulfone derivatives, phenoxazine derivatives, acrydine derivatives, and the like.

The thermally activated delayed fluorescence light-emitting dopant material is not particularly limited, and specific examples thereof are listed hereinbelow.

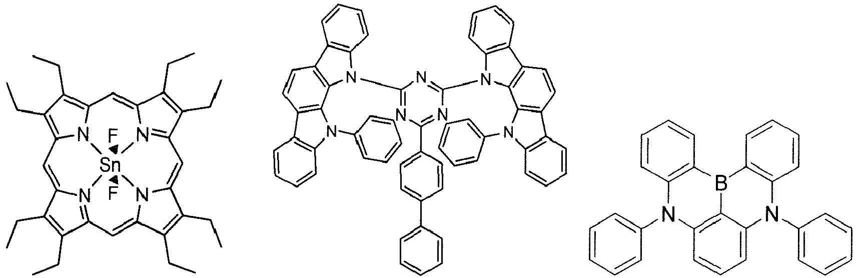

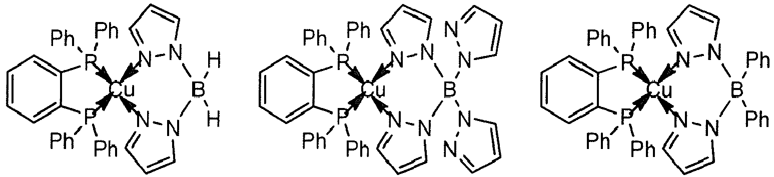

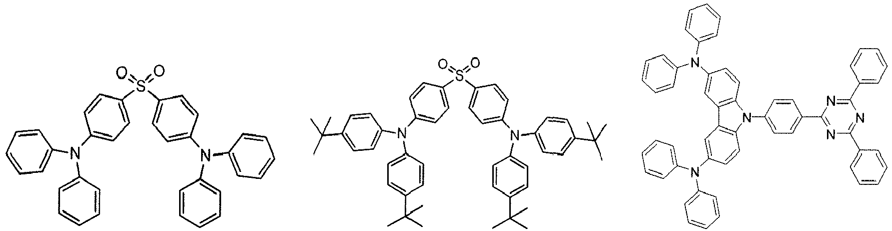

Only one kind of the thermally activated delayed fluorescence light-emitting dopant material or two or more kinds thereof may be contained in the light-emitting layer. The thermally activated delayed fluorescence light-emitting dopant may be used in a mixture with a phosphorescent light-emitting dopant or a fluorescent light-emitting dopant. The amount of the thermally activated delayed fluorescence light-emitting dopant material is preferably 0.1% to 50% and more preferably 1% to 30% with respect to the host material.

### Injection Layer

The injection layer is a layer provided between the electrode and the organic layer in order to reduce the driving voltage and improve the emission brightness. There are a hole injection layer and an electron injection layer, and they may be present between the anode and the light-emitting layer or the hole transport layer, and between the cathode and the light-emitting layer or the electron transport layer. The injection layer can be provided as needed.

### Hole-blocking Layer

The hole-blocking layer has a function of an electron transport layer in a broad sense, and is composed of a hole-blocking material having a very small ability to transport holes while having a function of transporting electrons. Therefore, it is possible to improve the recombination probability of electrons and holes in the light-emitting layer by blocking holes while transporting electrons.

A known hole-blocking layer material can be used for the hole-blocking layer.

### Electron Blocking Layer

The electron blocking layer has a function of a hole transporting layer in a broad sense, and can increase the probability of recombination of electrons and holes in the light-emitting layer by blocking electrons while transporting holes.

A known electron-blocking layer material can be used as a material for the electron-blocking layer. Further, the material of the below-described hole transport layer can be used as needed. The film thickness of the electron-blocking layer is preferably 3 nm to 100 nm, and more preferably 5 nm to 30 nm.

### Exciton-Blocking Layer

The exciton-blocking layer is a layer for preventing the excitons generated by the recombination of holes and electrons in the light-emitting layer from diffusing into the charge transport layer. By inserting this layer, excitons can be efficiently confined in the light-emitting layer, and the light emission efficiency of the device can be improved. The exciton blocking layer can be inserted between two adjacent light-emitting layers in a device in which two or more light-emitting layers are adjacent to each other.

A known exciton-blocking layer material can be used as a material for the exciton-blocking layer. Examples thereof include 1,3-dicarbazolylbenzene (mCP) and bis(2-methyl-8-quinolinolato)-4-phenylphenylatoaluminum (III) (BAlq).

### Hole Transport Layer

The hole transport layer is made of a hole transport material having a function of transporting holes, and the hole transport layer may be provided as a single layer or a plurality of layers.

The hole transport material has either a hole injection or transport property or an electron barrier property, and may be either an organic substance or an inorganic substance. Any compound can be selected and used for the hole transport layer from conventionally known compounds. Examples of such hole transport materials include porphyrin derivatives, arylamine derivatives, triazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, oxazole derivatives, styrylanthracene derivatives, fluorenone derivatives, hydrazone derivatives, stilben derivatives, silazane derivatives, aniline copolymers, and conductive high molecular weight oligomers, especially thiophene oligomers, etc., and it is preferable to use porphyrin derivatives, arylamine derivatives, and styrylamine derivatives, it is more preferable to use arylamine compounds.

### Electron Transport Layer

The electron transport layer is made of a material having a function of transporting electrons, and the electron transport layer may be provided as a single layer or a plurality of layers.

The electron transport material (which may also serve as a hole-blocking material) may have a function of transmitting electrons injected from the cathode to the light-emitting layer. Any compound can be selected and used for the electron transport layer from conventionally known compounds, and examples thereof include polycyclic aromatic derivatives such as naphthalene, anthracene, phenanthroline, and the like, tris(8-quinolinolate) aluminum (III) derivatives, phosphine oxide derivatives, nitro-substituted fluorene derivatives, diphenylquinone derivatives, thiopyrandioxide derivatives, carbodiimides, freolenidene methane derivatives, anthracinodimethane and anthrone derivatives, bipyridine derivatives, quinoline derivatives, oxadiazole derivatives, benzimidazole derivatives, benzothiazole derivatives, indolocarbazole derivatives, and the like. Further, polymer materials in which these materials are introduced into a polymer chain or these materials are used as the main chain of a polymer can also be used.

### [Examples]

Hereinafter, the present invention will be described in more detail with reference to Examples, but the present invention is not limited to these Examples, and can be implemented in various forms without departing from the gist thereof. Compound 1-1 means a compound represented by formula 1-1, and the same applies to compound 2-2 and the like.

### Example 1

Each thin film was laminated by a vacuum vapor deposition method at a vacuum degree of 4.0×10⁻⁵ Pa on a glass substrate on which an anode made of ITO and having a film thickness of 110 nm was formed. First, CuPc was formed on the ITO to a thickness of 25 nm as a hole injection layer, and then NPD was formed to a thickness of 10 nm as a hole transport layer. Next, HT-1 was formed to a thickness of 10 nm as an electron-blocking layer. Next, compound 1-1 as the first host, compound 2-2 as the second host, and Ir(ppy)₃ as a light-emitting dopant were co-deposited from different vapor deposition sources to form a light-emitting layer with a thickness of 40 nm. At this time, the co-deposition was performed under the vapor deposition conditions where the concentration of Ir(ppy)₃ was 10 wt% and the weight ratio between the first host and the second host was 70:30. Furthermore, A was formed to a thickness of 5 nm as a hole-blocking layer. Next, ET-1 was formed to a thickness of 35 nm as an electron transport layer. Furthermore, LiF was formed to a thickness of 1 nm as an electron injection layer on the electron transport layer. Finally, on the electron injection layer, Al was formed as a cathode to a thickness of 70 nm to fabricate an organic EL device. When an external power source was connected to the obtained organic EL element and a DC voltage was applied, an emission spectrum with a maximum wavelength of 517 nm was observed, and it was found that emission from Ir(ppy)₃ was obtained.

### Examples 2 to 5 and Comparative Examples 1 and 2

Organic EL devices were produced in the same manner as in Example 1 except that the compounds shown in Table 1 were used as the first host and the second host in Example 1. When a DC voltage was applied to the obtained organic EL devices, an emission spectrum with a maximum wavelength of 517 nm was observed.

### Examples 6 and 7 and Comparative Example 3

Organic EL devices were produced in the same manner as in Example 1 except that the compounds shown in Table 1 were used as the first host and the second host in Example 1 and the co-deposition was performed under the vapor deposition conditions where the weight ratio of the first host and the second host was 50:50. When a DC voltage was applied to the obtained organic EL devices, an emission spectrum with a maximum wavelength of 517 nm was observed.

Table 1 shows the evaluation results obtained for the produced organic EL devices. In the table, the brightness, voltage, and power efficiency are the values when the drive current is 20 mA/cm², which are the initial characteristics. LT70 is the time it takes for the initial brightness to decay to 70%, and represents the life characteristic. The same applies to Tables 2 to 4.

**[Table 1]**

| | 1st host | 2nd host | Brightness (cd/m²) | Voltage (V) | Power efficiency (lm/W) | LT70 (h) |
|---|---|---|---|---|---|---|
| Ex. 1 | 1-1 | 2-2 | 14100 | 5.3 | 41.8 | 3800 |
| Ex. 2 | 1-1 | 2-10 | 14200 | 5.3 | 42.1 | 3800 |
| Ex. 3 | 1-1 | 2-9 | 14500 | 5.4 | 42.2 | 3800 |
| Ex. 4 | 1-1 | 2-3 | 14700 | 5.5 | 42.0 | 3800 |
| Ex. 5 | 1-1 | 2-7 | 13800 | 5.3 | 40.8 | 3800 |
| Ex. 6 | 1-1 | 2-4 | 14000 | 4.8 | 45.8 | 3400 |
| Ex. 7 | 1-1 | 2-9 | 14500 | 5.0 | 45.5 | 2700 |
| Comp. Ex. 1 | 1-1 | A | 14000 | 5.5 | 39.8 | 1900 |
| Comp. Ex. 2 | 1-1 | B | 14300 | 7.0 | 32.2 | 400 |
| Comp. Ex. 3 | 1-1 | A | 13300 | 5.6 | 37.3 | 1700 |

### Example 8

Each thin film was laminated by a vacuum vapor deposition method at a vacuum degree of 4.0×10⁻⁵ Pa on a glass substrate on which an anode made of ITO and having a film thickness of 110 nm was formed. First, HAT-CN was formed on the ITO to a thickness of 25 nm as a hole injection layer, and then NPD was formed to a thickness of 10 nm as a hole transport layer. Next, HT-1 was formed to a thickness of 10 nm as an electron-blocking layer. Next, compound 1-1 as the first host, compound 2-4 as the second host, and Ir(ppy)₃ as a light-emitting dopant were co-deposited from different vapor deposition sources to form a light-emitting layer with a thickness of 40 nm. At this time, the co-deposition was performed under the vapor deposition conditions where the concentration of Ir(ppy)₃ was 10 wt% and the weight ratio between the first host and the second host was 70:30. Next, ET-1 was formed to a thickness of 40 nm as an electron transport layer. Furthermore, LiF was formed to a thickness of 1 nm as an electron injection layer on the electron transport layer. Finally, on the electron injection layer, Al was formed as a cathode to a thickness of 70 nm to fabricate an organic EL device.

When an external power source was connected to the obtained organic EL element and a DC voltage was applied, an emission spectrum with a maximum wavelength of 517 nm was observed, and it was found that emission from Ir(ppy)₃ was obtained.

### Examples 9 to 13 and Comparative Examples 6 to 8

Organic EL devices were produced in the same manner as in Example 8 except that the compounds shown in Table 2 were used for the first host and the second host in Example 8. When a DC voltage was applied to the obtained organic EL devices, an emission spectrum with a maximum wavelength of 517 nm was observed.

### Examples 14 to 19 and Comparative Examples 9 to 11

Organic EL devices were produced in the same manner as in Example 8 except that the compounds shown in Table 2 were used for the first host and the second host in Example 8 and the co-deposition was performed under the vapor deposition conditions where the weight ratio of the first host and the second host was 60:40. When a DC voltage was applied to the obtained organic EL devices, an emission spectrum with a maximum wavelength of 517 nm was observed.

**[Table 2]**

| | 1st host | 2nd host | Brightness (cd/m²) | Voltage (V) | Power efficiency (lm/W) | LT70 (h) |
|---|---|---|---|---|---|---|
| Ex. 8 | 1-1 | 2-4 | 14500 | 4.7 | 49.0 | 4100 |
| Ex. 9 | 1-2 | 2-4 | 14100 | 4.5 | 48.9 | 3600 |
| Ex. 10 | 1-2 | 2-9 | 14100 | 4.5 | 48.9 | 4100 |
| Ex. 11 | 1-2 | 2-3 | 14300 | 4.6 | 48.5 | 4100 |
| Ex. 12 | 1-3 | 2-4 | 14300 | 4.6 | 48.3 | 3200 |
| Ex. 13 | 1-3 | 2-3 | 14500 | 4.7 | 48.0 | 3600 |
| Ex. 14 | 1-1 | 2-4 | 14500 | 4.3 | 53.6 | 4800 |
| Ex. 15 | 1-1 | 2-2 | 13700 | 4.2 | 51.8 | 3300 |
| Ex. 16 | 1-1 | 2-10 | 14300 | 4.2 | 54.1 | 3600 |
| Ex. 17 | 1-1 | 2-9 | 14400 | 4.4 | 52.0 | 3600 |
| Ex. 18 | 1-1 | 2-3 | 14800 | 4.5 | 52.2 | 3200 |
| Ex. 19 | 1-1 | 2-7 | 14000 | 4.2 | 52.3 | 4100 |
| Comp.Ex.6 | 1-3 | C | 14900 | 5.2 | 44.9 | 3000 |
| Comp.Ex.7 | 1-1 | A | 14000 | 4.8 | 46.0 | 2300 |
| Comp.Ex.8 | 1-1 | B | 14300 | 6.2 | 36.0 | 500 |
| Comp.Ex.9 | 1-3 | C | 15500 | 5.0 | 48.6 | 2600 |
| Comp.Ex.10 | 1-1 | A | 14600 | 4.6 | 49.6 | 2600 |
| Comp.Ex.11 | 1-1 | B | 14900 | 6.0 | 39.1 | 500 |

### Example 20

Each thin film was laminated by a vacuum vapor deposition method at a vacuum degree of 4.0×10⁻⁵ Pa on a glass substrate on which an anode made of ITO and having a film thickness of 110 nm was formed. First, HAT-CN was formed on the ITO to a thickness of 25 nm as a hole injection layer, and then NPD was formed to a thickness of 30 nm as a hole transport layer. Next, HT-1 was formed to a thickness of 10 nm as an electron-blocking layer. Next, compound 1-1 as the first host, compound 2-1 as the second host, and Ir(ppy)₃ as a light-emitting dopant were co-deposited from different vapor deposition sources to form a light-emitting layer with a thickness of 40 nm. At this time, the co-deposition was performed under the vapor deposition conditions where the concentration of Ir(ppy)₃ was 8 wt% and the weight ratio between the first host and the second host was 70:30. Next, ET-1 was formed to a thickness of 20 nm as an electron transport layer. Furthermore, LiF was formed to a thickness of 1 nm as an electron injection layer on the electron transport layer. Finally, on the electron injection layer, Al was formed as a cathode to a thickness of 70 nm to fabricate an organic EL device.

When an external power source was connected to the obtained organic EL element and a DC voltage was applied, an emission spectrum with a maximum wavelength of 517 nm was observed, and it was found that emission from Ir(ppy)₃ was obtained.

### Examples 21 to 23 and Comparative Examples 13 to 15

Organic EL devices were produced in the same manner as in Example 20 except that the compounds shown in Table 3 were used for the first host and the second host in Example 20. When a DC voltage was applied to the obtained organic EL devices, an emission spectrum with a maximum wavelength of 517 nm was observed.

### Example 24 and Comparative Example 17

Organic EL devices were produced in the same manner as in Example 20 except that the compounds shown in Table 3 were used for the first host and the second host in Example 20 and the co-deposition was performed under the vapor deposition conditions where the weight ratio of the first host and the second host was 50:50. When a DC voltage was applied to the obtained organic EL devices, an emission spectrum with a maximum wavelength of 517 nm was observed.

### Comparative Examples 18 to 21

Organic EL devices were produced in the same manner as in Example 20 except that the compounds shown in Table 3 were used for the host in Example 20 and the co-deposition was performed under the vapor deposition conditions where a single host was obtained. When a DC voltage was applied to the obtained organic EL devices, an emission spectrum with a maximum wavelength of 517 nm was observed.

**[Table 3]**

| | 1st host | 2nd host | Brightness (cd/m²) | Voltage (V) | Power efficiency (lm/W) | LT70 (h) |
|---|---|---|---|---|---|---|
| Ex. 20 | 1-1 | 2-1 | 12500 | 4.5 | 44.1 | 3600 |
| Ex. 21 | 1-2 | 2-1 | 13000 | 4.4 | 46.6 | 3600 |
| Ex. 22 | 1-2 | 2-11 | 12000 | 4.4 | 43.3 | 3300 |
| Ex. 23 | 1-3 | 2-1 | 12600 | 4.5 | 43.8 | 3600 |
| Ex. 24 | 1-3 | 2-5 | 13200 | 4.0 | 52.5 | 2500 |
| Comp. Ex. 13 | 1-1 | A | 11100 | 4.4 | 40.1 | 1500 |
| Comp.Ex.14 | 1-1 | B | 12100 | 6.0 | 31.8 | 400 |
| Comp.Ex.15 | E | F | 9700 | 4.7 | 32.8 | 600 |
| Comp.Ex.17 | 1-1 | A | 11300 | 3.9 | 46.1 | 1500 |
| Comp.Ex.18 | - | A | 10200 | 3.6 | 45.1 | 600 |
| Comp.Ex.19 | - | B | 11300 | 5.4 | 33.2 | 100 |
| Comp.Ex.20 | - | 2-11 | 10200 | 3.5 | 46.4 | 1000 |
| Comp.Ex.21 | - | 2-12 | 10300 | 3.5 | 46.9 | 900 |

### Example 25

Each thin film was laminated by a vacuum vapor deposition method at a vacuum degree of 4.0×10⁻⁵ Pa on a glass substrate on which an anode made of ITO and having a film thickness of 110 nm was formed. First, CuPc was formed on the ITO to a thickness of 25 nm as a hole injection layer, and then NPD was formed to a thickness of 30 nm as a hole transport layer. Next, HT-1 was formed to a thickness of 10 nm as an electron-blocking layer. Next, compound 1-2 as the first host, compound 2-8 as the second host, and Ir(ppy)₃ as a light-emitting dopant were co-deposited from different vapor deposition sources to form a light-emitting layer with a thickness of 40 nm. At this time, the co-deposition was performed under the vapor deposition conditions where the concentration of Ir(ppy)₃ was 10 wt% and the weight ratio between the first host and the second host was 70:30. Further, A was formed as a hole-blocking layer to a thickness of 10 nm. Next, ET-1 was formed to a thickness of 10 nm as an electron transport layer. Furthermore, LiF was formed to a thickness of 1 nm as an electron injection layer on the electron transport layer. Finally, on the electron injection layer, A1 was formed as a cathode to a thickness of 70 nm to fabricate an organic EL device.

When an external power source was connected to the obtained organic EL element and a DC voltage was applied, an emission spectrum with a maximum wavelength of 517 nm was observed, and it was found that emission from Ir(ppy)₃ was obtained.

### Examples 26 to 28 and Comparative Examples 24 and 25

Organic EL devices were produced in the same manner as in Example 25 except that the compounds shown in Table 4 were used for the first host and the second host in Example 25. When a DC voltage was applied to the obtained organic EL devices, an emission spectrum with a maximum wavelength of 517 nm was observed.

### Examples 29 to 35 and Comparative Examples 28 and 29

Organic EL devices were produced in the same manner as in Example 25 except that the compounds shown in Table 4 were used for the first host and the second host in Example 25 and the co-deposition was performed under the vapor deposition conditions where the weight ratio of the first host and the second host was 60:40. When a DC voltage was applied to the obtained organic EL devices, an emission spectrum with a maximum wavelength of 517 nm was observed.

### Comparative Examples 30 to 33

Organic EL devices were produced in the same manner as in Example 25 except that the compounds shown in Table 4 were used for the host in Example 25 and the co-deposition was performed under the vapor deposition conditions where a single host was obtained. When a DC voltage was applied to the obtained organic EL devices, an emission spectrum with a maximum wavelength of 517 nm was observed.

**[Table 4]**

| | 1st host | 2nd host | Brightness (cd/m²) | Voltage (V) | Power efficiency (lm/W) | LT70 (h) |
|---|---|---|---|---|---|---|
| Ex. 25 | 1-2 | 2-8 | 11000 | 5.1 | 33.9 | 2400 |
| Ex. 26 | 1-4 | 2-12 | 12100 | 5.2 | 36.5 | 2900 |
| Ex. 27 | 1-2 | 2-2 | 12700 | 5.1 | 38.9 | 3500 |
| Ex. 28 | 1-3 | 2-2 | 12300 | 5.3 | 36.7 | 3500 |
| Ex. 29 | 1-2 | 2-13 | 12500 | 5.0 | 39.3 | 2100 |
| Ex. 30 | 1-3 | 2-13 | 12200 | 5.1 | 37.4 | 2100 |
| Ex. 31 | 1-1 | 2-2 | 12500 | 4.9 | 40.1 | 3200 |
| Ex. 32 | 1-3 | 2-8 | 11100 | 4.9 | 35.6 | 3300 |
| Ex. 33 | 1-3 | 2-6 | 13400 | 4.9 | 42.9 | 2300 |
| Ex. 34 | 1-3 | 2-5 | 13200 | 5.0 | 41.4 | 3500 |
| Ex. 35 | 1-2 | 2-8 | 11300 | 4.7 | 37.7 | 2000 |
| Comp.Ex.24 | 1-1 | A | 11100 | 5.1 | 34.2 | 1300 |
| Comp.Ex.25 | 1-1 | B | 12100 | 6.7 | 28.2 | 300 |
| Comp.Ex.28 | 1-1 | A | 11300 | 4.8 | 37.2 | 1200 |
| Comp.Ex.29 | 1-1 | B | 12500 | 6.5 | 30.2 | 300 |
| Comp.Ex.30 | - | A | 10200 | 4.3 | 37.2 | 500 |
| Comp.Ex.31 | - | B | 11300 | 6.1 | 29.1 | 100 |
| Comp.Ex.32 | - | 2-13 | 11900 | 4 . 4 | 42.5 | 1100 |
| Comp.Ex.33 | - | 2-8 | 9800 | 4.1 | 37.5 | 800 |

### Examples 36 to 40, Comparative Example 34

Organic EL devices were produced in the same manner as in Example 25 except that a premix obtained by weighing the first host (0.70 g) and the second host (0.30 g) shown in Table 4 and mixing them while grinding in a mortar was co-deposited from one vapor deposition source. When a DC voltage was applied to the obtained organic EL device, an emission spectrum with a maximum wavelength of 517 nm was observed.

**[Table 5]**

| | 1st host | 2nd host | Brightness (cd/m²) | Voltage (V) | Power efficiency (lm/W) | LT70 (h) |
|---|---|---|---|---|---|---|
| Ex. 36 | 1-1 | 2-2 | 12200 | 5.2 | 36.8 | 3500 |
| Ex. 37 | 1-3 | 2-6 | 12600 | 5.3 | 37.3 | 3300 |
| Ex. 38 | 1-3 | 2-5 | 12400 | 5.4 | 36.1 | 3400 |
| Ex. 39 | 1-2 | 2-5 | 12100 | 5.2 | 36.5 | 3500 |
| Ex. 40 | 1-2 | 2-6 | 12900 | 5.2 | 39.2 | 3300 |
| Comp.Ex.34 | G | A | 11500 | 5.5 | 32.8 | 1500 |

It is understood that the combinations of the compounds shown in the examples described in Tables 1 to 5 improve power efficiency or life characteristics of the devices as compared with a single material or a combination of compounds shown in Comparative Examples.

The compounds used in the Examples are shown below.

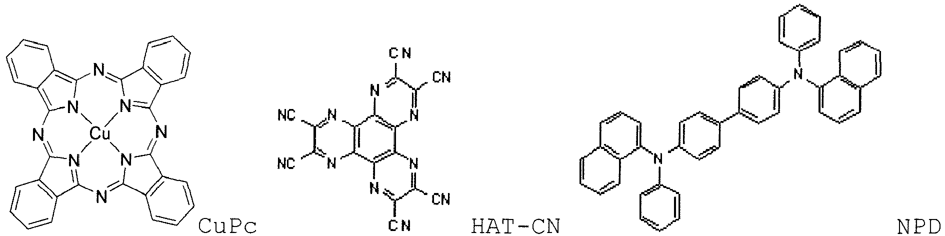

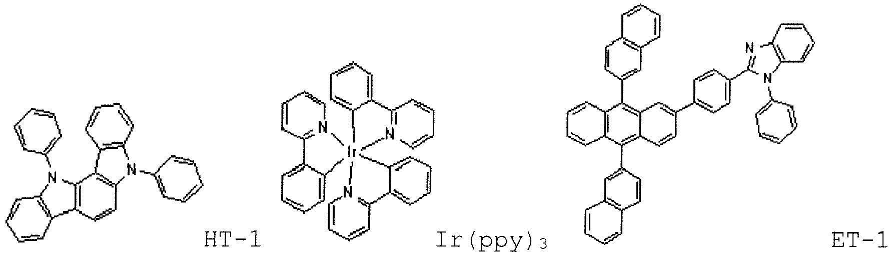

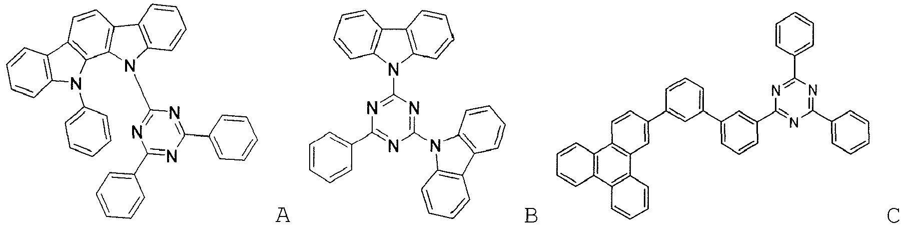

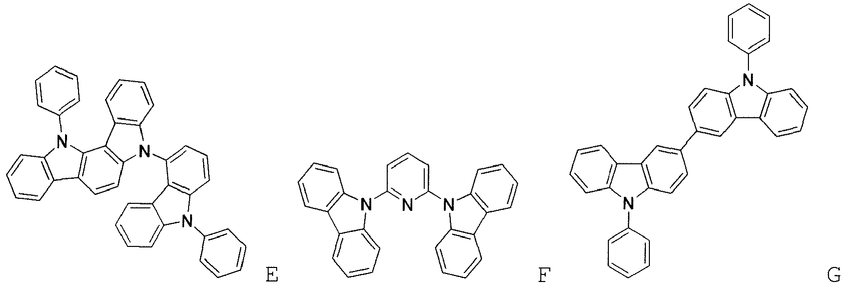

Table 6 shows the 50% weight loss temperature (T₅₀) of compounds 1-1, 1-2, 1-3, 2-2, 2-3, 2-5, 2-6, 2-12, 2-13, compound A, and compound G.

**[Table 6]**

| Compound | T₅₀ [°C] | Compound | T₅₀ [°C] |
|---|---|---|---|
| 1-1 | 277 | 2-6 | 303 |
| 1-2 | 317 | 2-12 | 286 |
| 1-3 | 315 | 2-13 | 278 |
| 2-2 | 273 | A | 235 |
| 2-3 | 276 | G | 226 |
| 2-5 | 309 | | |

## Claims

1. An organic electroluminescent element comprising:
an anode and a cathode that face each other, and
one or more light-emitting layers that are present between the anode and the cathode, wherein
at least one of the light-emitting layers contains a first compound selected from compounds represented by following formula (1), a second compound selected from compounds represented by following formula (2), and a luminous dopant material: 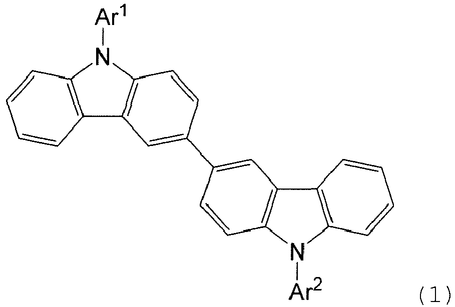 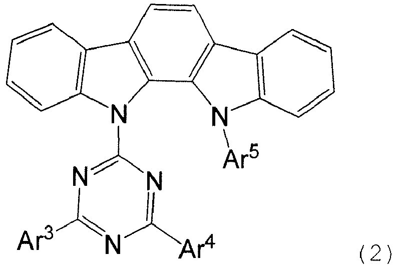
in formula (1), Ar¹ is represented by any of following formulas (1A) to (1D), and Ar² is represented by any of following formulas (1B) to (1D);
in formula (2), Ar³ and Ar⁴ are independently represented by any one selected from the group consisting of following formulas (1A) to (1D) and formulas (2A) to (2F), and Ar⁵ is represented by any one selected from the group consisting of following formulas (1A) to (1D) and formulas (2A) to (2C);
* represents a bonding position;
provided that cases where Ar¹ in formula (1) is formula (1A), Ar² is formula (1B), Ar³ in formula (2) is formula (1A), Ar⁴ is formula (1B), and Ar⁵ is formula (1C),
and Ar¹ is formula (1A), Ar² is formula (1B), Ar³ is formula (1A), Ar⁴ is formula (1A), and Ar⁵ is formula (2B) are excluded.

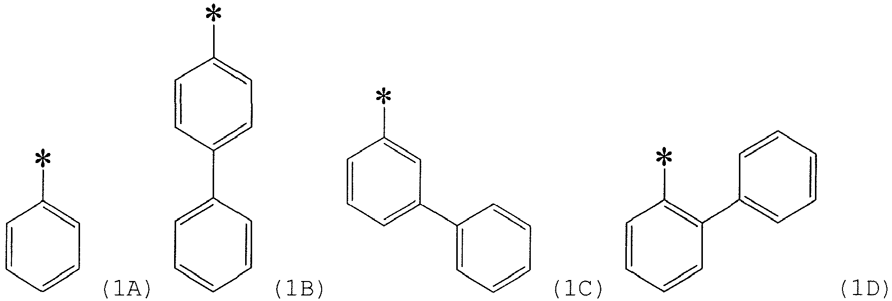

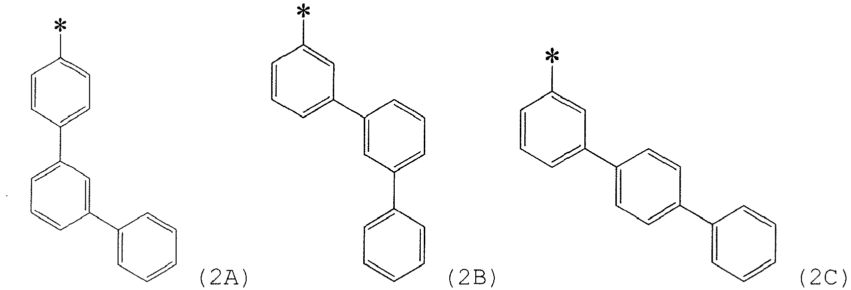

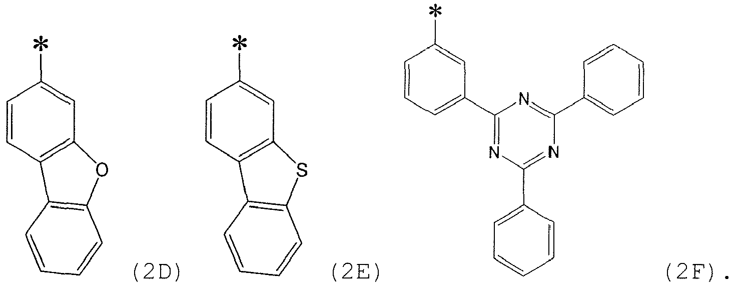

2. The organic electroluminescent element according to claim 1, wherein the compound represented by formula (1) is a compound represented by any one of following formulas 1-1 to 1-9, and the compound represented by formula (2) is a compound represented by any one of following formulas 2-1 to 2-17: 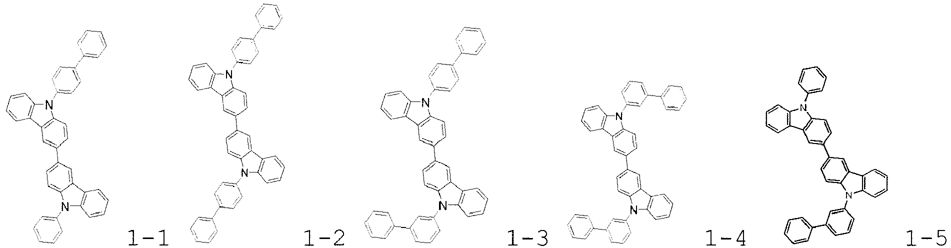 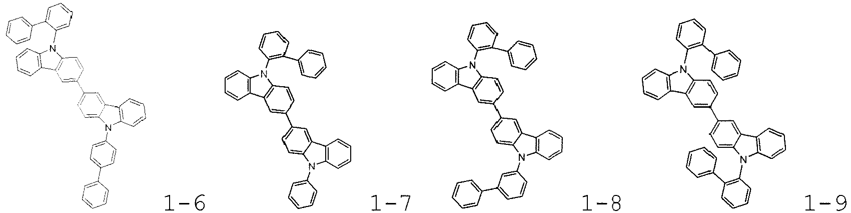 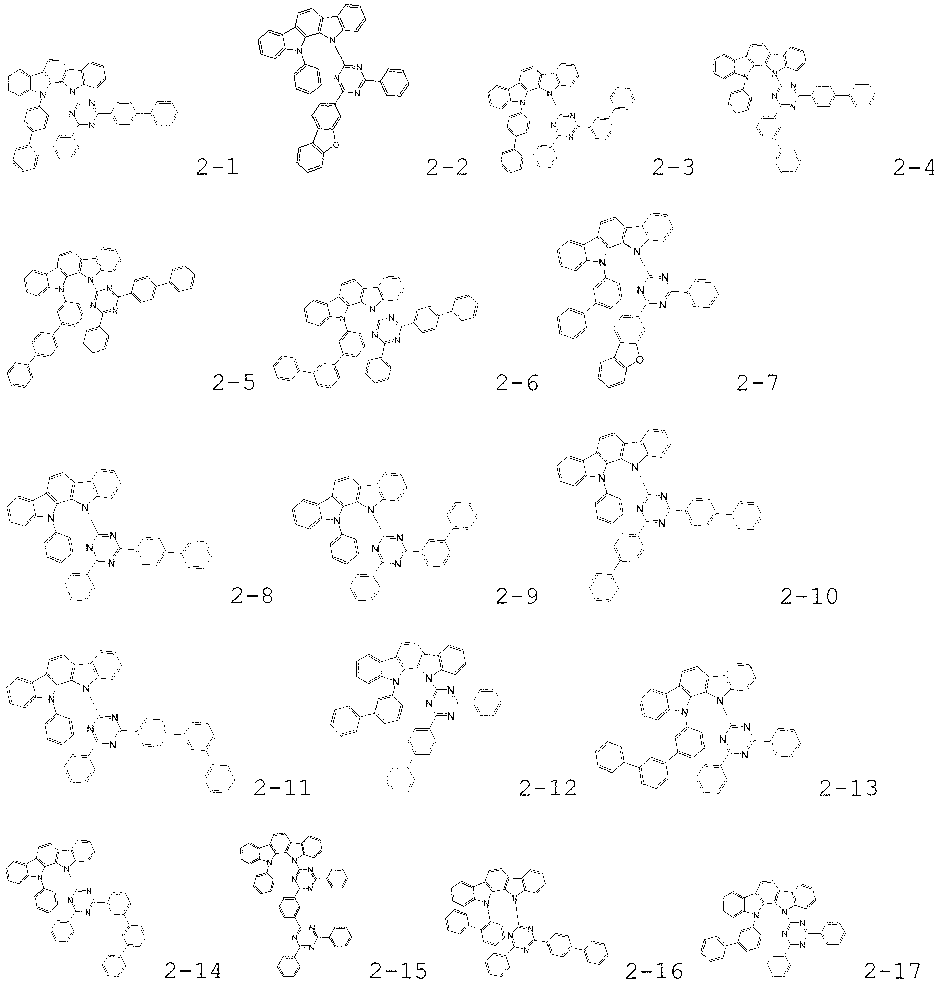 provided that, a case where the first compound is of formula 1-1 and the second compound is of formula 2-12 or 2-13 is excluded.

3. The organic electroluminescent element according to claim 2, wherein the first compound is a compound represented by any one of formulas 1-1 to 1-4, and the second compound is any one of formulas 2-1 to 2-11.

4. The organic electroluminescent element according to claim 3, wherein the second compound is a compound represented by any one of formulas 2-1 to 2-7.

5. The organic electroluminescent element according to any one of claims 1-4, wherein the proportion of the second compound is more than 20 wt% and less than 60 wt% with respect to the total of the first compound and the second compound.

6. The organic electroluminescent element according to any one of claims 1-5, wherein the luminous dopant material is an organometallic complex including at least one metal selected from the group consisting of ruthenium, rhodium, palladium, silver, rhenium, osmium, iridium, platinum, and gold.

7. The organic electroluminescent element according to any one of claims 1-5, wherein the luminous dopant material is a fluorescent dopant material including a thermally activated delayed fluorescence light-emitting material.

8. A method for producing an organic electroluminescent element, the method being for producing the organic electroluminescent element according to any one of claims 1 to 7, and the method comprising:
preparing a composition that contains the first compound and the second compound, and forming a light-emitting layer by vapor-depositing or coating the composition.

9. The method for producing an organic electroluminescent element according to claim 8, further comprising: mixing the first compound and the second compound to obtain a composition composed of a premixture, and forming a light-emitting layer by vapor-depositing a material containing this composition and a luminous dopant material.

10. The method for producing an organic electroluminescent element according to claim 9, wherein a difference in the 50% weight loss temperature between the first compound and the second compound is within 20°C.

11. A composition for an organic electroluminescent device, the composition being for use in the method for producing an organic electroluminescent device according to claim 9 or 10, and the composition comprising the first compound and the second compound.
